Europäisches Patentamt

(19) European Patent Office

Office européen des brevets

(11) Publication number: **0 108 945**
**B1**

(12) **EUROPEAN PATENT SPECIFICATION**

(45) Date of publication of patent specification: **11.03.87**

(21) Application number: **83110354.4**

(22) Date of filing: **18.10.83**

(51) Int. Cl.⁴: **H 01 L 29/90,** H 01 L 21/76, H 01 L 27/06, H 01 L 27/08

(54) **High voltage semiconductor devices with reduced on-resistance.**

(30) Priority: **25.10.82 US 436244**

(43) Date of publication of application:
**23.05.84 Bulletin 84/21**

(45) Publication of the grant of the patent:
**11.03.87 Bulletin 87/11**

(84) Designated Contracting States:
**CH DE FR GB LI NL SE**

(56) References cited:
**EP-A-0 098 383**
**DE-A-2 007 627**
**DE-A-2 102 103**
**FR-A-2 412 946**

**IEEE TRANSACTIONS ON ELECTRON DEVICES, vol. ED-28, no. 3, March 1981, pages 275-280, IEEE, New York, US A.K. KAPOOR et al.: "Variable N-type negative resistance in an injection-gated double-injection diode"**

(73) Proprietor: **GENERAL ELECTRIC COMPANY**
**1 River Road**
**Schenectady New York 12305 (US)**

(72) Inventor: **Baliga, Bantval Jayant**
**3 Clove Court**
**Clifton Park New York, 12065 (US)**
Inventor: **Wildi, Eric Joseph**
**39 Canterbury Road**
**Clifton Park New York 12065 (US)**

(74) Representative: **Tiedtke, Harro, Dipl.-Ing. et al**
**Patentanwaltsbüro Tiedtke-Bühling-Kinne-Grupe-Pellmann-Grams-Struif Bavariaring 4**
**Postfach 20 24 03**
**D-8000 München 2 (DE)**

Courier Press, Leamington Spa, England.

**Description**

The present invention relates to a high voltage semiconductor device according to the prior-art portion of claim 1.

A high voltage semiconductor device of this type is described in DE—A—2 102 103. This known semiconductor device comprises a bulk substrate of one conductivity type with a layer of opposite conductivity type thereon. There are furthermore provided three regions extending into the layer from the upper surface thereof, wherein the first region is of the opposite conductivity type and the second and third regions are of the one conductivity type. The first and second regions therefore are forming the cathode and the anode, respectively, of a diode. As the third region is interposed between the cathode and anode regions and as it form a P—N junction with the layer it can be used as a gate, so that during the forward bias condition of the diode the degree of conductivity of the layer between the cathode and anode regions can be controlled by suitably biasing the gate.

In particular, when the gate is biased to be more negative than the threshold voltage the diode is in a current-blocking state, whereas the on-resistance of the diode is more and more reduced when the gate is gradually made less negative than the threshold voltage. However, the value of on-resistance of this known semiconductor device cannot be made smaller than the value of on-resistance of a conventional diode having no gate.

Accordingly, there has been proposed an improved semiconductor device which is described in EP—A1—0098393 having an earlier priority date but published after the filing date of the present invention. This device comprises a thin $N^-$ layer atop a $P^-$ substrate, wherein a $N^+$ cathode region and a $P^+$ anode region are extending into the $N^-$ layer from its upper surface, the anode region surrounding the cathode region. To reduce parasitic currents, an $N^+$ buried layer exists between the $P^-$ substrate and the $N^-$ layer, beneath the $P^+$ anode region, so as to surround the $N^+$ cathode region. In order to avoid the loss of voltage-supporting capability in the $N^-$ layer between the cathode region and the $N^+$ buried layer, a further $P^+$ region extends into the $N^-$ layer from its upper surface and is interposed between the cathode region and the anode region so as to surround the cathode region and, in turn, be surrounded by the anode region. The further $P^+$ region is permanently biased near or at the potential of the substrate, whereby the $N^-$ layer supports reverse voltages in the device.

The foregoing P—N diode attains a reasonably low value of on-resistance. It would be desirable, however, to provide a diode having an even lower value of on-resistance. It furthermore would be desirable to provide the same low value of on-resistance for a semiconductor device forming a bipolar transistor.

It is an object of the present invention to provide a semiconductor device according to the prior-art portion of claim 1 having a lower value of on-resistance than previously attainable.

According to the invention this object is achieved by the advantageous measures as indicated in the characterizing portion of claim 1.

According to the invention there can be obtained a semiconductor device whose on-resistance is dramatically reduced, so that power losses and voltage drop across the device are correspondingly reduced. Furthermore the device can easily be formed as a P—N diode or as a bipolar transistor. Finally it is possible to form semiconductor devices employed to attain such reduced on-resistance along with such a high voltage semiconductor device in a single integrated circuit.

Advantageous improvements of the invention are subject-matter of the subclaims.

In the following the invention will be described in more detail with reference to the drawing Figures, in which:

Figure 1 is a schematic view in cross-section of a portion of a P—N diode in accordance with the present invention;

Figure 2 is a view of a modified P—N diode incorporating an alternative bias means in accordance with the present invention;

Figure 3 is a detail view of a portion of the P—N diode of Figure 1; and

Figure 4 is a view of a modification of the structure of Figure 3 for implementing a bipolar transistor.

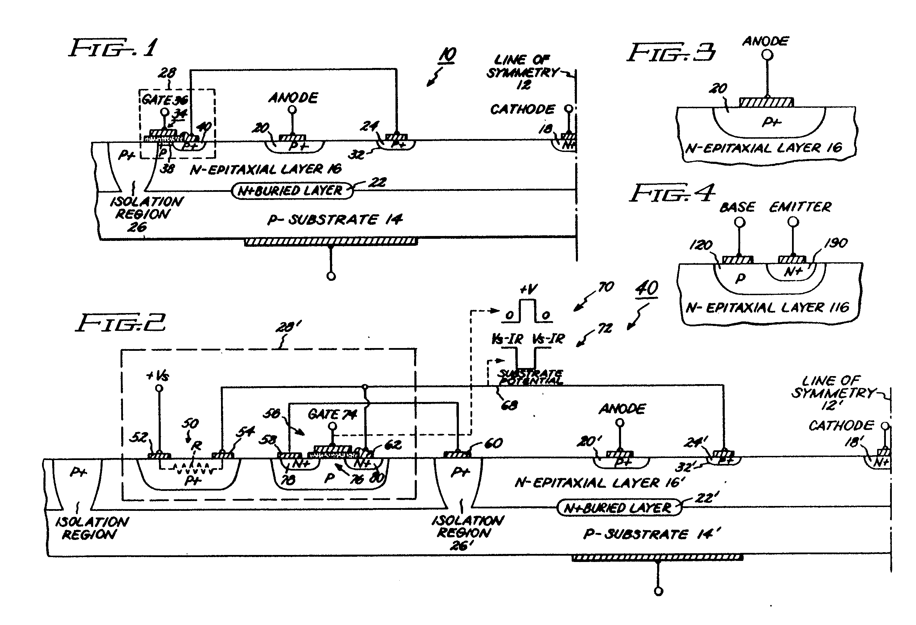

Figure 1 illustrates a portion of a P—N diode 10 to the left of a line of symmetry 12. P—N diode 10 suitably comprises a bulk $P^-$ substrate 14, preferably silicon, with an $N^-$ layer 16 thereon, preferably an epitaxial silicon layer. An $N^+$ cathode region 18 extends into the $N^-$ layer 16 from the upper surface thereof. A $P^+$ anode region 20 extends into $N^-$ layer 16 from its upper surface and surrounds $N^+$ region 18 as viewed from above. $N^+$ buried layer 22 is situated between $N^-$ layer 16 and $P^-$ substrate 14, beneath $P^+$ anode region 20 and surrounds $N^+$ cathode region 18. A further $P^+$ region 24 extends into $N^-$ layer 16 from its upper surface, surrounds $N^+$ cathode region 18, and, in turn, is surrounded by $P^+$ anode region 20. A $P^+$ isolation region 26 is integrally connected to $P^-$ substrate 14, and surrounds the periphery of $N^-$ layer 16, thereby enabling other semiconductor devices to be formed, along with P—N diode 10, in an integrated circuit.

The presence of $N^+$ buried layer 22 in P—N diode 10 serves to reduce parasitic currents in diode 10 that otherwise would exist. The presence of $P^+$ region 24, appropriately biased to a potential approximately equal to or slightly more positive than that of $P^-$ substrate 14 when diode 10 is in a current-blocking state, enables the portion of $N^-$ epitaxial layer 16 between $P^+$ region 24 and $N^+$ cathode 18 to support high reverse voltages. This is because, without $P^+$ region 24 so biased $N^+$ buried layer 22 would rise in potential to that of $N^+$ cathode 18, leaving only the thin region of $N^-$

layer 16 between N$^+$ buried layer 22 and P$^+$ anode region 20 to support reverse voltages. Such thin region of N$^-$ layer 16 would likely break down under high reverse voltage.

Furthermore there is provided a bias means 28 for supplying P$^+$ region 24 with a plurality of different bias drives so as to differently bias P—N junction 32, extant between P$^+$ region 24 and N$^-$ layer 16. The different biasing conditions of P—N junction 32 serve to effect different degrees of conductivity in the N$^-$ layer 16 between P$^+$ anode region 20 and N$^+$ cathode region 18, as will be described more fully hereinbelow.

Bias means 28, in the exemplary embodiment illustrated, comprises a depletion mode (i.e., normally-conducting) P-channel metal-oxide-semiconductor field effect transistor (MOSFET) 34. MOSFET 34, in the absence of any bias voltage on its gate 36, electrically shorts P$^+$ region 24 to P$^+$ isolation region 26, which is at the potential of P$^-$ substrate 14. This is because, in such state of MOSFET 34, P-channel 38 of MOSFET 34 provides a high conductivity path between P$^+$ region 40, which is electrically shorted to P$^+$ region 24, and P$^+$ isolation region 26. When gate 36 is biased with a positive voltage in excess of a threshold value so as to deplete P-channel 38 of holes and thereby reduce it conductivity, P$^+$ region 24 is open circuited, that is, supplied with a bias drive of zero current. This zero current bias drive of P$^+$ region 24 advantageously results in P—N diode 10 having a lower value of on-resistance than if P$^+$ region 24 were biased to the potential of P$^-$ substrate 14. This is because, in P—N diode 10, there is a much smaller depletion region extending into N$^-$ layer 16 from P—N junction 32, in contrast to the case where P$^+$ region 24 is biased to the P$^-$ substrate 14 potential, such as appertains to the P—N diode of the above-referenced application.

Bias means 28 with MOSFET 34 is preferably formed along with P—N diode 10 in a single integrated circuit. However, bias means 28 could be implemented as a separate device. Bias means 28 is an exemplary bias means for P$^+$ region 24, and could be implemented in many different forms. For example, MOSFET 34 of bias means 28 could be replaced by other switching means, such as a bipolar transistor. Moreover, the bias means for P$^+$ region 24 could be implemented as a bias means 28', which is illustrated in Figure 2.

Figure 2 depicts a P—N diode 40, which is identical to P—N diode 10 (Figure 1) except for the inclusion of a different bias means 28' for the corresponding P$^+$ region 24', shown to the left of P$^+$ isolation region 26'. The different bias means 28' includes a resistance means 50 of ohmic value R having a terminal 52 adapted to be connected to a source of voltage (not shown) so as to be biased at a positive voltage, V$_s$, and a further terminal 54, which is connected to P$^+$ region 24'. Bias means 28' further includes an enhancement mode or normally-off MOSFET 56. One terminal 58 of MOSFET 56 is electrically shorted, via electrode 60, to P$^+$ isolation region 26', which is at the potential of P$^-$ substrate 14. Another terminal 62 of MOSFET 56 is electrically shorted, via conductor 68, to P$^+$ region 24'.

Bias means 28' is effective to produce, via conductor 68, two different bias drives on P$^+$ region 24'. These two different bias drives can be readily understood by considering voltage pulses 70 and 72, which can be determined by monitoring gate 74 of MOSFET 56 and conductor 68, respectively.

With zero bias voltage on gate 74, the voltage on conductor 68 is equal to the bias voltage V$_s$ on terminal 52, reduced by the $IR$ (or current×resistance) voltage drop across resistance means 50. Consequently, P$^+$ region 24' is supplied with a bias drive characterized by the voltage on conductor 68 and by a current limited by the combined resistances of the voltage source (not shown) which biases terminal 52 to V$_s$ volts, the resistance means 50, and the resistance through P$^+$ region 24' to a ground or reference level.

With gate 74 of MOSFET 56 biased at a positive voltage, V$_s$, above a threshold value, an inversion layer is formed in region 76 of MOSFET 56, beneath gate 74. The inversion layer is highly conductive to electrons, and, together with N$^+$ regions 78 and 80, completes a current path from terminal 58, which is at the potential of P$^-$ substrate 14', to conductor 68, via terminal 62, thereby biasing conductor 68 to the potential of P$^-$ substrate 14'. With conductor 68 so biased, P$^+$ region 24' is supplied with a bias drive characterized by the P$^-$ substrate 14' potential and by no current (or zero level current), since P—N junction 32', between P$^+$ region 24' and N$^-$ layer 16' is reverse biased.

When P—N diode 40 is operating in its current-blocking state, P$^+$ region 24' should be supplied with a bias drive characterized by the potential of P$^-$ substrate 14' and zero current. When P—N diode 40 is operating in its current-conducting state, however, P$^+$ region 24' should be supplied with a bias drive characterized by being at the potential V$_s$, as reduced by the $IR$ voltage drop across resistance means 50. With such potential of P$^+$ region 24' being greater than about one volt above the potential of P$^+$ anode region 20', at least for silicon devices, P—N junction 32', between P$^+$ region 24' and N$^-$ layer 16', is forward biased, and, in accordance with an important aspect of the present invention P$^+$ region 24' thereby injects holes into N$^-$ layer 16'. Then, in accordance with the principle of quasi-neutrality (as discussed for example, in R. S. Muller and T. I. Kamins, *Device Electronics for Integrated Circuits*, New York, N.Y.: Wiley & Sons (1977), pages 105, 111 and 112 the concentration of electrons in N$^-$ layer 16' increases to approximately that of the holes injected thereinto by P$^+$ region 24'. As a result, the resistance of N$^-$ layer 16', between P$^+$ anode region 20' and N$^+$ cathode region 18', is reduced, thereby reducing the on-resistance of P—N diode 40 so as to achieve a main objective of our invention.

While resistance means 50 and MOSFET 56 are illustrated in the preferred embodiment in which they are formed along with P—N diode 40 in a single integrated circuit, such devices could alternatively be formed as separate devices. If devices 50 and 56 are formed in a single integrated circuit as illustrated, it is desirable that P⁺ isolation region 26' be interposed between P—N diode 40 and such devices. P⁺ isolation region 26' could be omitted, however, if the distance of separation between P—N diode 40 and such devices is sufficient to prevent adverse electrical interference therebetween, although this would result in more space consumed in the integrated circuit.

The present invention is also useful in semiconductor devices other than P—N diodes, such as bipolar transistors. To make a bipolar transistor requires a variation of the structure associated with P⁺ anode region 20 (Figure 1), which is illustrated in the detail view of Figure 3. Appropriate modified structure is shown i Figure 4, in which P base region 120 corresponds to P⁺ anode region 20 of Figure 3. In Figure 4, N⁺ emitter region 190 extends into P base region 120 from the upper surface of region 120, and surrounds an N⁺ collector region (not illustrated) which corresponds to N⁺ cathode region 18 of P—N diode 10 (Figure 1).

In fabricating the devices illustrated herein, each of the regions shown as extending into a device from the upper surface thereof can be formed by either diffusion or ion implantation, and the N⁺ buried layers can be formed by either diffusion or ion implantation through the upper surface of the respective P⁻ substrate prior to the growth of the respective N⁻ epitaxial layer thereon.

In the best mode we contemplate for practising the present invention, the mathematical product of the thickness and doping concentration of the N⁻ epitaxial layer of each device described herein is selected in accordance with Reduced Surface Field (or RESURF) Technology in order to maximize the reverse voltage attainable by each device. Details of RESURF Technology may be found, for example, in an article by J. A. Appels and H. M. J. Vaes "High Voltage Thin Layer Devices (RESURF Devices)", Proceedings of the 1979 IEEE International Electron Device Meeting, pages 238—241, as well as in an article by S. Colak, B. Singer and E. Stupp. "Design of High-Density Power Lateral DMOS Transistors", Proceedings of the 1980 IEEE Power Electronics Specialists Conference, pages 164—167.

**Claims**

1. A semiconductor device comprising a bulk substrate (14, 14') of one conductivity type with a layer (16, 16') of opposite conductivity type thereon, and including first and second regions, said first region (18, 18') being of said opposite conductivity type and extending into said layer from the upper surface thereof and said second region (20, 20') being of said one conductivity type extending into said layer from said upper surface and a third region (24, 24') of said one conductivity type extending into said layer from said upper surface and forming a P—N junction (32; 32') therewith and being situated between said first and second regions to control the degree of conductivity in said layer between said first and second regions,

characterised in that the device comprises a fourth region (22; 22') of said opposite conductivity type buried between said layer and said substrate beneath said second region surrounding said first region and having a dopant concentration higher than that of said layer, so as to reduce parasitic currents in the device,

in that said second region (20; 20') surrounds said first region (18; 18'),

in that said third region (24; 24') surrounds said first region (18; 18') and is in turn surrounded by said second region and

in that there are provided bias means (28, 28') comprising switching means (34; 56) coupled to said third region (24; 24') by a current path so as to supply said fourth region selectively with a plurality of different bias drives, one at a time, so as to effect different degrees of conductivity in said layer between said first and second regions.

2. Semiconductor device according to claim 1 wherein said switching means (34, 56) is adapted to controllably connect said fourth region (22, 22') to said bulk substrate (14, 14').

3. Semiconductor device according to claim 1 wherein said switching means is adapted to controllably open circuit said current path to said fourth region (22, 22').

4. Semiconductor device according to claim 1 wherein said switching means is adapted to at least connect said fourth region (22, 22') to said bulk substrate (14, 14'), and, at a different time, to open circuit said current path to said fourth region.

5. Semiconductor device according to claim 4 wherein said switching means comprises a MOSFET (34; 56) having a bulk substrate in common with said bulk substrate (14, 14') of the semiconductor device.

6. Semiconductor device according to claim 1 wherein said switching means is adapted to alternately connect said fourth region (22, 22') to said bulk substrate (14, 14') and open circuit said current path to said fourth region.

7. Semiconductor device according to claim 1 wherein a voltage lead (52) adapted for connection to a voltage source (Vs) is provided, said switching means (34; 56) controllably connecting said fourth region (22, 22') to said voltage lead (52).

8. Semiconductor device according to claim 7 wherein an impedance means (R) is provided in the current path between said fourth region and said voltage lead.

9. Semiconductor device according to claim 8 wherein said impedance means (R) comprises a further region (50) of said one conductivity type extending into said layer from said upper surface and surrounding said first region.

10. Semiconductor device according to claim 1 wherein said switching means is adapted to forward bias said P—N junction (32, 32') to such an extent that said fourth region injects current carriers into said layer.

11. Semiconductor device according to claim 1 wherein a voltage lead (52) adapted for connection to a voltage source (Vs) is provided, said switching means at least connecting said fourth region (22, 22') to said voltage lead, and, at a different time, to said bulk substrate (14, 14').

12. Semiconductor device according to claim 11 wherein an impedance means (R) is provided in the current path between said fourth region and said voltage lead.

13. Semiconductor device according to claim 12 wherein said impedance means (R) comprises a further region (50) of said one conductivity type extending into said layer from said upper surface and surrounding said first region.

14. Semiconductor device according to claim 13 wherein said switching means comprises a MOSFET having a bulk substrate in common with said bulk substrate (14, 14') of the semiconductor device.

15. Semiconductor device according to claim 1 wherein a voltage lead adapted for connection to a voltage source (Vs) is provided, said switching means alternately connecting said fourth region (22, 22') to said voltage lead and to said bulk substrate (14, 14').

16. Semiconductor device according to claim 1 wherein an isolation region (26) integrally connected to said substrate and surrounding the periphery of said layer is provided.

17. Semiconductor device according to claim 1 wherein an additional region (190) of said opposite conductivity type extending into said second region (120) from the upper surface thereof and surrounding said first region is provided.

18. Semiconductor device according to claim 1 wherein said bulk substrate and said second (20, 20') and fourth regions (22, 22') comprise semiconductor material of P-type conductivity and said layer (16, 16') of said first (18, 18') and third regions (24, 24') comprise semiconductor material of N-type conductivity.

19. Semiconductor device according to claim 18 wherein said bulk substrate, said layer, and said first, second, third and fourth regions each comprise silicon semiconductor material.

**Patentansprüche**

1. Halbleitervorrichtung mit einem Massensubstrat (14, 14') des einen Leitfähigkeitstyps mit einer darauf befindlichen Schicht (16, 16') des entgegengesetzten Leitfähigkeitstyps sowie mit einer ersten und zweiten Region, wobei die erste Region (18, 18') den entgegengesetzten Leitfähigkeitstyp hat und sich von der oberen Oberfläche der Schicht her in diese erstreckt, die zweite Region (20, 20') den einen Leitfähigkeitstyp hat und sich von deren oberer Oberfläche her in die Schicht erstreckt und wobei eine dritte Region (24, 24') den einen Leitfähigkeitstyp hat, sich von deren oberer Oberfläche her in die Schicht erstreckt, mit dieser einen P—N-Übergang (32; 32') bildet und zwischen der ersten und zweiten Region angeordnet ist, um das Leitvermögen in der Schicht zwischen der ersten un zweiten Region zu steuern,

dadurch gekennzeichnet, daß die Vorrichtung eine zwischen der Schicht und dem Substrat neben der zweiten Region vergrabene und die erste Region umgebende vierte Region (22; 22') des entgegengesetzten Leitfähigkeitstyps ausweist, derern Dotierungsgrad größer als der der Schicht ist, um parasitäre Ströme in der Vorrichtung zu verringern,

daß die zweite Region (20; 20') die erste Region (18; 18') umgibt,

daß die dritte Region (24; 24') die erste Region (18; 18') umgibt und ihrerseits von der zweiten Region umgeben ist und daß eine Vorspanneinrichtung (28, 28') mit einer über einen Strompfad mit der dritten Region (24; 24') gekoppelten Schalteinrichtung (34; 56) vorgesehen ist, um der vierten Region selektiv aus einer Vielzahl verschiedener Treiber-Vorspannungen jeweils eine zuzuführen, um in der Schicht zwischen der ersten und zweiten Region unterschiedliche Leitvermögen hervorzurufen.

2. Halbleitervorrichtung nach Anspruch 1, dadurch gekennzeichnet, daß mit der Schalteinrichtung (34, 56) die vierte Region (22, 22') steuerbar mit dem Massensubstrat (14, 14') verbindbar ist.

3. Halbleitervorrichtung nach Anspruch 1, dadurch gekennzeichnet, daß mit der Schalteinrichtung (34, 56) der Strompfad zur vierten Region (22, 22') steuerbar unterbrechbar ist.

4. Halbleitervorrichtung nach Anspruch 1, dadurch gekennzeichnet, daß die Schalteinrichtung dazu eingerichtet ist, zumindest die vierte Region (22, 22') mit dem Massensubstrat (14, 14') zu verbinden und—zu einer verschiedenen Zeit—den Strompfad zur vierten Region zu unterbrechen.

5. Halbleitervorrichtung nach Anspruch 4, dadurch gekennzeichnet, daß die Schalteinrichtung einen MOSFET (34; 56) aufweist, der sein Massensubstrat gemeinsam mit dem Massensubstrat (14, 14') der Halbleitervorrichtung hat.

6. Halbleitervorrichtung nach Anspruch 1, dadurch gekennzeichnet, daß die Schalteinrichtung dazu eingerichtet ist, abwechselnd die vierte Region (22, 22') mit dem Massensubstrat (14, 14') zu verbinden und den Strompfad zur vierten Region zu unterbrechen.

7. Halbleitervorrichtung nach Anspruch 1, dadurch gekennzeichnet, daß eine zur Verbindung mit einer Spannungsquelle (Vs) geeignete Spannungsleitung (52) vorgesehen ist, wobei die Schalteinrichtung (34; 56) die vierte Region (22, 22') steuerbar mit der Spannungsleitung (52) verbindet.

8. Halbleitervorrichtung nach Anspruch 7, dadurch gekennzeichnet, daß in dem Strompfad zwischen der vierten Region und der Spannungsleitung eine Impedanzeinrichtung (R) vorgesehen ist.

9. Halbleitervorrichtung nach Anspruch 8, dadurch gekennzeichnet, daß die Impedanzeinrichtung (R) eine sich von deren oberer Oberfläche her in die Schicht erstreckende und die erste Region umgebende weitere Region (50) des einen Leitfähigkeitstyps aufweist.

10. Halbleitervorrichtung nach Anspruch 1, dadurch gekennzeichnet, daß mit der Schalteinrichtung der P—N-Übergang (32, 32') in einem solchen Maß in Vorwärtsrichtung vorspannbar ist, daß die vierte Region Ladungsträger in die Schicht injiziert.

11. Halbleitervorrichtung nach Anspruch 1, dadurch gekennzeichnet, daß eine zur Verbindung mit einer Spannungsquelle (Vs) geeignete Spannungsleitung (52) vorgesehen ist, wobei die Schalteinrichtung (34; 56) zumindest die vierte Region (22, 22') mit der Spannungsleitung und—zu einer verschiedenen Zeit—mit dem Massensubstrat (14, 14') verbindet.

12. Halbleitervorrichtung nach Anspruch 11, dadurch gekennzeichnet, daß in dem Strompfad zwischen der vierten Region und der Spannungsleitung eine Impedanzeinrichtung (R) vorgesehen ist.

13. Halbleitervorrichtung nach Anspruch 12, dadurch gekennzeichnet, daß die Impedanzeinrichtung (R) eine sich von deren oberer Oberfläche her in die Schicht erstreckende und die erste Region umgebende weitere Region (50) des einen Leitfähigkeitstyps aufweist.

14. Halbleitervorrichtung nach Anspruch 13, dadurch gekennzeichnet, daß die Schalteinrichtung einen MOSFET (34; 56) aufweist, der sein Massensubstrat gemeinsam mit dem Massensubstrat (14, 14') der Halbleitervorrichtung hat.

15. Halbleitervorrichtung nach Anspruch 1, dadurch gekennzeichnet, daß eine zur Verbindung mit einer Spannungsquelle (Vs) geeignete Spannungsleitung (52) vorgesehen ist, wobei die Schalteinrichtung (34; 56) die vierte Region (22, 22') abwechselnd mit der Spannungsleitung und mit dem Massensubstrat (14, 14') verbindet.

16. Halbleitervorrichtung nach Anspruch 1, dadurch gekennzeichnet, daß eine fest mit dem Substrat verbundene und den Randbereich der Schicht umgebende Isolierregion (26) vorgesehen ist.

17. Halbleitervorrichtung nach Anspruch 1, dadurch gekennzeichnet, daß eine sich von der oberen Oberfläche der zweiten Region (120) in diese erstreckende und die erste Region umgebende zusätzliche Region (190) des entgegengesetzten Leitungstyps vorgesehen ist.

18. Halbleitervorrichtung nach Anspruch 1, dadurch gekennzeichnet, daß das Massensubstrat und die zweite (20, 20') und vierte Region (22, 22') Halbleitermaterial mit P-Leitfähigkeit und die Schicht (16, 16') und die erste (18, 18') und dritte Region (24, 24') Halbleitermaterial mit N-Leitfähigkeit enthalten.

19. Halbleitervorrichtung nach Anspruch 18, dadurch gekennzeichnet, daß das Massensubstrat, die Schicht sowie die erste, zweite, dritte und vierte Region jeweils Silizium-Halbleitermaterial enthalten.

**Revendications**

1. Dispositif semi-conducteur comprenant un substrat de corps (14, 14') d'un premier type de conductivité avec une couche (16, 16') d'un type de conductivité opposé sur son dessus, et comportant des première et seconde régions, la première région (18, 18') étant du type de conductivité opposé et s'étendant jusque dans la couche à partir de sa surface supérieure et la seconde région (20, 20') étant du premier type de conductivité et s'étendant jusque dans la couche à partir de la surface supérieure et une troisième région (24, 24') du premier type de conductivité s'étendant jusque dans la couche à partir de la surface supérieure et formant une jonction P—N (32; 32') avec celle-ci et étant située entre les première et seconde régions pour contrôler le degré de conductivité dans ladite couche entre les première et seconde régions, caractérisé en ce que le dispositif comprend une quatrième région (22; 22') du type de conductivité opposé ensevelie entre la couche et le substrat au-dessous de la seconde région entourant la première région et avant une concentration en dopant supérieure à celle de la couche, de manière à réduire les courants parasites dans le dispositif, en ce que la seconde région (20; 20') entoure la première région (18; 18'), en ce que la troisième région (24; 24') entoure la première région (18; 18') et est à son tour entourée par la seconde région et,

en ce qu'on a prévu un moyen de polarisation (28; 28') comprenant un moyen de commutation (34; 56) couplé à la troisième région (24; 24') par un trajet de courant de manière à appliquer sélectivement à la quatrième région une multitude de commandes de polarisation différentes, une à la fois, dans le but d'effectuer des degrés de conductivité différents dans la couche entre les première et seconde régions.

2. Dispositif semi-conducteur selon la revendication 1, dans lequel le moyen de commutation (34, 56) est destiné à connecter de manière contrôlée la quatrième région (22; 22') au substrat du corps (14, 14').

3. Dispositif semi-conducteur selon la revendication 1, dans lequel le moyen de commutation est destiné à ouvrir de manière contrôlée le trajet de courant jusqu'à la quatrième région (22; 22').

4. Dispositif semi-conducteur selon la revendication 1, dans lequel le moyen de commutation est destiné à au moins connecter la quatrième région (22; 22') au substrat du corps (14, 14'), et, à un instant différent, à ouvrir le circuit du trajet de courant jusqu'à la quatrième région.

5. Dispositif semi-conducteur selon la revendication 4, dans lequel le moyen de commutation comprend un transistor MOSFET (34; 56) ayant un substrat du corps en commun avec le substrat du corps (14, 14') du dispositif semi-conducteur.

6. Dispositif semi-conducteur selon la revendication 1, dans lequel le moyen de commutation est destiné à connecter alternativement la quatrième région (22, 22') au substrat du corps (14, 14) et à ouvrir le circuit de trajet de courant jusqu'à la quatrième région.

7. Dispositif semi-conducteur selon la revendication 1, dans lequel un fil de tension (52) destiné à effectuer la connexion à une source de tension ($V_s$) est fourni, le moyen de commutation (34; 56) connectant de manière contrôlable la quatrième région (22, 22') au fil de tension (52).

8. Dispositif semi-conducteur selon la revendication 7, dans lequel un moyen d'impédance (R) est prévu dans le trajet de courant entre la quatrième région et le fil de tension.

9. Dispositif semi-conducteur selon la revendication 8, dans lequel le moyen d'impédance (R) comprend une autre région (50) du premier type de conductivité s'étendant jusque dans la couche à partir de la surface supérieure et entourant la première région.

10. Dispositif semi-conducteur selon la revendication 1, dans lequel le moyen de commutation est destiné à polariser directement la jonction P—N (32, 32') à un degré tel que la quatrième région injecte des porteurs de courant dans la couche.

11. Dispositif semi-conducteur selon la revendication 1, dans lequel un fil de tension (52) destiné à établir la connexion avec une source de tension ($V_s$) est prévu, le moyen de commutation connectant au moins la quatrième région (22, 22') au fil de tension, et, à un instant différent, au substrat du corps (14, 14').

12. Dispositif semi-conducteur selon la revendication 11, dans lequel un moyen d'impédance (R) est prévu dans le trajet de courant entre la quatrième région et le fil de tension.

13. Dispositif semi-conducteur selon la revendication 12, dans lequel le moyen d'impédance (R) comprend une autre région (50) du premier type de conductivité s'étendant jusque dans la couche à partir de la surface supérieure et entourant la première région.

14. Dispositif semi-conducteur selon la revendication 13, dans lequel le moyen de commutation comprend un transistor MOSFET ayant un substrat du corps en commun avec le substrat du corps (14, 14') du dispositif semi-conducteur.

15. Dispositif semi-conducteur selon la revendication 1, dans lequel un fil de tension destiné à être connecté à une source de tension ($V_s$) est prévu, le moyen de commutation connectant alternativement la quatrième région (22, 22') au fil de tension et au substrat du corps (14, 14').

16. Dispositif semi-conducteur selon la revendication 1, dans lequel une région d'isolement (26) connectée intégralement au substrat en entourant la périphérie de la couche est fournie.

17. Dispositif semi-conducteur selon la revendication 1, dans lequel une région supplémentaire (190) du type de conductivité opposé s'étendant jusque dans la seconde région (120) à partir de sa surface supérieure et entourant la première région est fournie.

18. Dispositif semi-conducteur selon la revendication 1, dans lequel le substrat du corps et les seconde (20, 20') et quatrième (22, 22') régions comprennent un matériau semi-conducteur ayant une conductivité du type P et la couche (16, 16') et les première (18, 18') et troisième (24, 24') régions comprennent un matériau semi-conducteur ayant une conductivité du type N.

19. Dispositif semi-conducteur selon la revendication 18, dans lequel le substrat du corps, la couche, et les première, seconde, troisième et quatrième régions comprennent chacun du matériau semi-conducteur en silicium.

FIG.1

FIG.2

FIG.3

FIG.4